(19) Europäisches Patentamt
European Patent Office
Office européen des brevets

(11) **EP 0 862 816 B1**

(12) # FASCICULE DE BREVET EUROPEEN

(45) Date de publication et mention de la délivrance du brevet:
**25.08.1999 Bulletin 1999/34**

(21) Numéro de dépôt: **96939144.0**

(22) Date de dépôt: **19.11.1996**

(51) Int Cl.6: **H04B 1/30**, H03C 1/60, H03D 1/24

(86) Numéro de dépôt international:
**PCT/FR96/01824**

(87) Numéro de publication internationale:
**WO 97/19521 (29.05.1997 Gazette 1997/23)**

(54) **PROCEDE ET DISPOSITIF POUR L'ELIMINATION DE RESIDUS DE SIGNAL DANS DES MODULATEURS-DEMODULATEURS DE SIGNAUX EN QUADRATURE**

ELIMINATIONSSCHALTUNG UND -VERFAHREN FÜR RESTSIGNALE VON QUADRATURSIGNALMODULATOREN/-DEMODULATOREN

METHOD AND DEVICE FOR REMOVING SIGNAL RESIDUES IN QUADRATURE SIGNAL MODULATOR-DEMODULATORS

(84) Etats contractants désignés:
**DE ES GB IT**

(30) Priorité: **23.11.1995 FR 9513945**

(43) Date de publication de la demande:
**09.09.1998 Bulletin 1998/37**

(73) Titulaire: **THOMSON-CSF**
**75008 Paris (FR)**

(72) Inventeur: **FUCHE, Loic, Thomson-CSF S.C.P.I.**
**F-94117 Arcueil Cédex (FR)**

(74) Mandataire: **Lincot, Georges et al**
**THOMSON-CSF,**
**Propriété Intellectuelle,**
**Département Protection et Conseil,**
**TPI/PC,**
**13, av. du Prés. Salvador Allende**
**94117 Arcueil Cédex (FR)**

(56) Documents cités:
**EP-A- 0 206 402** **US-A- 5 115 468**
**US-A- 5 446 423**

- **ELECTRONIC DESIGN, vol. 39, no. 11, 13 Juin 1991, CLEVELAND,OH,US, pages 89-91, 93, 96, XP000236889 GROSHONG R ET AL: "EXPLOIT DIGITAL ADVANTAGES IN AN SSB RECEIVER"**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 0 862 816 B1

## Description

La présente invention concerne un procédé et un dispositif pour l'élimination de résidus de signal en dehors de la bande de fréquence utile d'émetteurs-récepteurs radioélectriques utilisant des modulateurs-démodulateurs formés de voies en quadrature, tel que p. ex. décrit dans le document US-A-5 115 468 ou encore EP-A-0 206 402.

Elle s'applique notamment à la réalisation de modulateurs-démodulateurs pour émetteurs-récepteurs à bande latérale unique.

Classiquement, pour un émetteur utilisant des voies en quadrature, et de manière décrite par exemple dans le livre de M Philip F. Panter ayant pour titre "Modulation, noise, and spectral analysis" pages 192 à 196 publié par McGraw-Hill Book Company (1965) le signal basse fréquence qui est appliqué à l'entrée d'un modulateur composé de deux voies en quadratures, est mélangé à l'intérieur de ces deux voies avec un signal porteur foumi par un oscillateur local pour obtenir un signal modulé dont la fréquence correspond à celle du signal porteur. En recombinant par exemple dans un circuit additionneur les signaux fournis par les deux voies, le spectre en fréquence du signal modulé qui est obtenu, se compose de deux bandes latérales de fréquence symétriquement disposées de part et d'autre de la fréquence du signal porteur. Dans les réalisations d'émetteurs-récepteurs à bande latérale unique, le signal obtenu à la sortie du modulateur devrait ne comporter qu'une bande si le modulateur était parfait. Un résidu, lié au déséquilibre des voies existe cependant bien que filtré par le filtre passe-bande placé en sortie du modulateur. Dans ces conditions, la distance entre la bande utile et la bande résiduelle est égale à deux fois la fréquence minimum Fmini. A titre d'exemple, cet écart n'est que de 600 Hz pour des spectres basse fréquence dont la fréquence minimum n'est que de 300 Hz. Ce faible écart en fréquence entre les deux bandes latérales présente un risque, pour un émetteur récepteur trafiquant sur un canal adjacent, d'être brouillé par le signal occupant la bande de fréquence résiduelle.

Le déséquilibre des voies en quadrature des modulateurs d'émission et de réception qui entraîne l'apparition de résidus de signal à l'extérieur de la bande de fréquence utile dans la bande latérale du spectre qui est symétrique de celle de la bande latérale utile par rapport à la fréquence porteuse, est le plus souvent lié à des disparités de gain ou de phase entre voies ou encore à des fluctuations des points de polarisation des différents étages d'amplification composant les voies. Aussi, généralement, l'utilisation de voies en quadratures nécessite dans les émetteurs modernes d'effectuer des corrections par un traitement numérique du signal qui exige une forte puissance de calcul et qui ne peut malheureusement être appliqué sur un émetteur autre que sur lequel ces corrections sont dédiées.

Le but de l'invention est de pallier les inconvénients précités.

A cet effet, l'invention a pour objet, un procédé pour éliminer les résidus de signal en dehors de la bande de fréquence utile d'émetteurs-récepteurs de signaux radioélectriques utilisant un modulateur-démodulateur de signaux en quadrature composé de deux voies en quadratures et suivant lequel le signal basse fréquence à émettre qui est appliqué à l'entrée des deux voies, est mélangé par un signal porteur fourni par un oscillateur local caractérisé en ce qu'il consiste à décaler le spectre du signal basse fréquence à transmettre appliqué sur les voies en quadrature et à supprimer par filtrage la bande résiduelles indésirable du spectre du signal obtenu en sortie des deux voies en quadrature par un filtre dont la bande passante est calée sur la bande de fréquence utile de l'émetteur.

L'invention a également pour objet un dispositif pour la mise en oeuvre du procédé précité.

L'invention a pour avantage qu'elle permet de s'affranchir ou de réduire de façon significative le niveau des résidus de signal en sortie du modulateur d'émission et de ce fait d'améliorer les performances des modulaleurs en quadrature, en particulier, lorsqu'ils sont utilisés dans des émetteurs récepteurs à bande latérale unique. L'utilisation des modulateurs/démodulateurs en quadrature s'en trouve ainsi facilité, puisqu'il n'y a plus nécessité à équilibrer les voies. Du point de vue algorithmie, le procédé selon l'invention a aussi pour avantage de n'exiger qu'une puissance de calcul qui reste inférieure par rapport à celle qui peut être exigée par un algorithme de correction de déséquilibre de voies classique. -D'autre part, le bruit proche de l'oscillateur utilisé pour la transposition de fréquence sur les voies en quadratures n'est plus préjudiciable au signal utile, en particulier pour les performances en réception du fait que, ce dernier se trouve décalé de la fréquence porteuse. De la sorte les contraintes habituellement rencontrées sur la pureté spectrale des oscillateurs se trouvent être réduites.

D'autres caractéristiques et avantages de l'invention apparaîtront dans la description qui suit faite en regard des dessins annexés qui représentent :

La figure 1 une représentation spectrale du décalage de la bande résiduelle par rapport à la bande utile obtenu en appliquant le procédé selon l'invention à un procédé de modulation à bande latérale unique.

La figure 2 un modulateur pour la mise en oeuvre du procédé selon l'invention.

Les figures 3A et 3B les spectres en fréquence comparés du signal de modulation obtenu d'une chaîne de modulation à double voies en quadratures selon l'art antérieur d'une part, et selon l'invention, d'autre part.

La figure 4 un mode de réalisation d'un dispositif de décalage de spectre.

Le risque de pollution d'un canal adjacent par la bande latérale résiduelle est minimisé selon l'invention en décalant, comme le montre la figure 1, le spectre basse fréquence d'une valeur d'une fréquence de décalage déterminée Fd. Ce décalage permet d'obtenir une fréquence minimum du spectre basse fréquence égale à : Fd+Fmini. La distance minimum entre la bande utile et la bande résiduelle devenant égale à 2x(Fd+Fmini), il suffit de choisir une valeur de Fd telle que le signal de la bande résiduelle soit en dehors de la bande du filtre passe bande de sortie du modulateur et de recaler le spectre final sur le canal de l'émetteur en décalant la fréquence de l'oscillateur en conséquence. Dans ces conditions les résidus, d'une part, de la fréquence, de l'oscillateur qui se trouve à Fd de la fréquence minimum du filtre passe bande et d'autre part, la bande résiduelle qui est située à 2xFd sont atténués par le filtre passe bande.

Pour obtenir ce résultat, le modulateur selon l'invention qui est représenté à la figure 2, comporte un dispositif de décalage de spectre basse fréquence 1 couplé à un circuit additionneur 2 par l'intermédiaire d'une première voie 3 et d'une deuxième voie 4 de modulation d'un signal à fréquence intermédiaire foumi par un oscillateur local 5 au travers d'un circuit déphaseur 6 de voie à 90°. Chacune des voies 3 et 4 se compose d'un convertisseur numérique analogique $7_3$ et $7_4$ relié à une première entrée d'un circuit multiplieur $8_3$ et $8_4$ par l'intermédiaire d'un filtre passe bas $9_3$ et $9_4$. Le signal obtenu en sortie du circuit additionneur 2 est filtré par un filtre passe bande 10 de la bande latérale utile du signal à transmettre.

Suivant cette disposition le signal basse fréquence à transmettre e(t) est appliqué sous la forme d'un signal numérique à l'entrée du dispositif de décalage de spectre 1 pour être décomposé en deux signaux A(t) et B(t) à spectres décalés suivant un écart déterminé de fréquence Fd de la façon représentée aux figures 3A et 3B. Ces signaux sont convertis en signaux analogiques par les convertisseurs numérique-analogique $7_3$ et $7_4$ associés aux filtres $9_3$ et $9_4$ avant d'être multipliés respectivement par les signaux fournis en sortie du déphaseur 6. La fréquence porteuse des signaux modulés obtenus en sortie des multiplieurs $8_3$ et $8_4$ correspond à celle de l'oscillateur 5.

Dans le mode de réalisation du dispositif de décalage de spectre qui est représenté à la figure 4, les signaux A(t) et B(t) sont obtenus aux sorties respectives de deux circuits multiplieurs 11 et 12 filtrées par deux filtres numériques 13 et 14. Les circuits multiplieurs 11 et 12 effectuent respectivement la transposition du signal basse fréquence échantillonné e(t) par deux signaux en quadratures de fréquence $\omega d/2\pi$ correspondant à la fréquence de décalage du spectre basse fréquence du signal e(t).De la sorte, pour chaque fréquence $\omega/2\pi$ du spectre du signal e(t) comprise par exemple entre 300 et 3000 Hz, le résultat des multiplications est composé d'échantillons de signaux vérifiant les relations :

$$A'_{(t)} = \cos \omega.t \times \cos\omega d.t \quad \text{et} \quad B'_{(t)} = \cos\omega.t \times \sin.\omega d.t$$

soit encore les relations :

$$A'(t) = 1/2\cos(\omega d-\omega)t + 1/2\cos(\omega d+\omega).t \quad \text{et} \quad B'(t)=1/2 \sin(\omega d-\omega).t + 1/2 \sin(\omega d+\omega).t.$$

Les filtrages numériques qui sont exercés par les filtres 13 et 14 permettent d'obtenir des signaux A(t) et B(t) vérifiant les relations $A(t)=K \cos(\omega d+\omega).t$ et $B(t)= K \sin(\omega d+\omega)t$ en éliminant les fréquences basses en $(\omega d - \omega)/2\pi$.

En appelant $\omega p$ la pulsation de l'oscillateur 5, ce qui précède permet d'établir en sortie des circuits multiplieurs $8_3$ et $8_4$ de la figure 1 des signaux I(t) et Q(t) vérifiant les relations:

$$I(t) = A(t) \times \cos(\omega p\ t) \text{ et } Q(t) = B(t) \times \sin(\omega p\ t)$$

soit encore

$$I(t) = K/2(\cos(\omega p-\omega d-\omega)t + \cos(\omega p + \omega d+ \omega)t)$$

$$Q(t) = K/2(\cos(\omega p-\omega d-\omega)t - \cos(\omega p + \omega d+ \omega)t)$$

dont la somme par l'additionneur 2 vaut

$$S(t) = K \cos(\omega p - \omega d-\omega)t.$$

A titre d'exemple, en prenant pour fréquence porteuse de l'oscillateur 5 la valeur 100,02 MHz, un spectre basse fréquence F compris dans l'intervalle 300, 3 000 Hz, une fréquence de décalage Fd = 20 KHz, le signal utile S (t) obtenu a la caractéristique d'un signal à bande latérale unique inférieure défini par la relation

$$S(t) = K \cos(2\pi 100 \text{ MHz} - \omega)t.$$

et le résidu du signal sur l'autre bande est rejeté à une distance 2(Fd + F min) de la première bande soit à 40,6 KHz de celle-ci au lieu de seulement 600 Hz s'il n'y avait pas eu de décalage du signal BF. On note aussi dans ces conditions que la fréquence fictive de l'onde porteuse n'est pas de 100,02 MHz mais de 100 MHz.

Pour le cas, où il serait nécessaire de transmettre la bande supérieure du signal à bande latérale unique des calculs similaires aux précédents sont alors à effectuer, en changeant par exemple la valeur de Q(t) définie précédemment par son opposée et en prenant pour valeur de la fréquence de l'oscillateur 5, Fp = 99, 98 MHz.

En réception le signal transmis par le filtre 10 est appliqué de la manière représentée à la figure 5 sur les entrées respectives d'un démodulateur comportant deux voies en quadratures. Chacune comprend un circuit mélangeur de fréquence $15_1$ et $15_2$ couplés à un convertisseur analogique numérique $16_1$ et $16_2$ par l'intermédiaire d'un filtre numérique passe bas $17_1$ et $17_2$. La mise en quadrature du signal reçu est assuré de façon connue par un signal fourni par un oscillateur appliqué respectivement sur une entrée de mélange des circuit mélangeurs $15_1$ et $15_2$. Un circuit additionneur 18 additionne les signaux obtenus en sortie des deux convertisseurs analogiques numériques 16 et le signal résultant est appliqué à l'entrée d'un filtre numérique 19 pour éliminer un des deux spectres résultant des mélanges des signaux entre les deux voies et le spectre indésirable lié au déséquilibre entre les deux voies.

Naturellement l'invention n'est pas limitée au mode de réalisation qui vient d'être décrit, on pourra notamment utiliser des processeurs de traitement de signal convenablement programmés ou encore des étages mélangeurs et filtres entièrement analogiques pour effectuer le décalage du spectre en fréquence à l'entrée des voies de transposition 3 et 4 de la figure 2.

## Revendications

1. Procédé pour éliminer les résidus de signal en dehors de la bande de fréquence utile d'émetteurs-récepteurs de signaux radioélectriques utilisant un modulateur-démodulateur de signaux en quadrature composé de deux voies en quadratures (3, 4) et suivant lequel le signal basse fréquence à émettre qui est appliqué à l'entrée des deux voies, est mélangé par un signal porteur foumi par un oscillateur local (5), caractérisé en ce qu'il consiste à décaler le spectre du signal basse fréquence à transmettre appliqué sur les voies en quadrature et à supprimer par filtrage (10) la bande résiduelle indésirable du spectre du signal obtenu en sortie des deux voies en quadrature par un filtre dont la bande passante est calée sur la bande de fréquence utile de l'émetteur.

2. Procédé selon la revendication 1, caractérisé en ce que le décalage en fréquence du spectre du signal basse fréquence a lieu sur chacune des voies par transposition en numérique de la fréquence du signal basse fréquence par deux signaux de même fréquence (Fd) échantillonnés en quadrature.

3. Dispositif pour éliminer les résidus de signal en dehors de la bande de fréquence utile d'un émetteur de signaux radioélectriques utilisant un modulateur de signaux en quadrature comprenant deux voies de transposition en quadrature (3, 4) pour transposer un signal basse fréquence à transmettre sur la fréquence d'un signal porteur et un filtre passe bande (10) couplé en sortie des deux voies de transposition (3, 4) pour filtrer une des deux bandes latérales du signal résultant de la transposition, caractérisé en ce qu'il comprend un dispositif de décalage du spectre (1) du signal basse fréquence à transmettre couplé à l'entrée des deux voies (3, 4).

4. Dispositif selon la revendication 3, caractérisé en ce que le dispositif de décalage de spectre comporte un ensemble de deux voies (11, 13; 12, 14) de transposition de fréquence en quadrature, la fréquence de transposition étant égale à la fréquence de décalage (Fd) du spectre basse fréquence.

5. Dispositif selon la revendication 4, caractérisé en ce que chacune des voies de transposition du dispositif de décalage de spectre (1) comprend un circuit multiplieur (11, 12) couplé à un filtre numérique (13, 14) pour effectuer une transposition en numérique du signal basse fréquence sur la fréquence de décalage.

6. Dispositif selon la revendication 5, caractérisé en ce que chaque filtre numérique (13, 14) du dispositif de décalage de spectre est couplé à un convertisseur numérique analogique ($7_3$, $7_4$) d'une voie de transposition (3, 4) du modulateur pour transposer le signal basse fréquence obtenu en sortie du filtre numérique (13, 14) sur la fréquence du signal porteur.

**Patentansprüche**

1. Verfahren zur Eliminierung der Signalreste außerhalb des Nutzfrequenzbands eines Sender/Empfängers von Funksignalen, der ein Quadratursignal-Modem mit zwei in Quadratur liegenden Kanälen (3, 4) verwendet, wobei das auszusendende Niederfrequenzsignal, das an den Eingang der beiden Kanäle angelegt wird, mit einem Trägerfrequenzsignal gemischt wird, das von einem örtlichen Oszillator geliefert wird, dadurch gekennzeichnet, daß das Verfahren darin besteht, daß das Spektrum des an die Kanäle in Quadratur angelegten und zu übertragenden Niederfrequenzsignals verschoben wird und das unerwünschte Restband des Spektrums des am Ausgang der beiden Quadraturkanäle erhaltenen Signals über ein Filter unterdrückt wird, dessen Durchlaßband auf das Nutzfrequenzband des Senders abgestimmt ist.

2. Verfahren nach Anspruch 1, dadurch gekennzeichnet, daß die Frequenzverschiebung des Spektrums des Niederfrequenzsignals auf jedem der Kanäle durch digitale Umsetzung der Frequenz des Niederfrequenzsignals mittels zweier getasteter Signale gleicher Frequenz (Fd) in Quadraturlage erfolgt.

3. Vorrichtung zur Eliminierung der Signalreste außerhalb des Nutzfrequenzbands eines Senders für funkelektrische Signale unter Verwendung eines Modulators für in Quadratur liegende Signale mit zwei in Quadratur liegenden Umsetzungskanälen (3, 4), um ein zu übertragendes Niederfrequenzband auf die Frequenz eines Trägers umzusetzen, und mit einem Bandpaßfilter (10), das an den Ausgang der beiden Umsetzungskanäle (3, 4) gekoppelt ist, um eines der beiden Seitenbänder des umgesetzten Signals auszufiltern, dadurch gekennzeichnet, daß sie eine Vorrichtung (1) zur spektralen Verschiebung des zu übertragenden Niederfrequenzsignals aufweist, die an den Eingang der beiden Kanäle (3, 4) gekoppelt ist.

4. Vorrichtung nach Anspruch 3, dadurch gekennzeichnet, daß die Vorrichtung zur spektralen Verschiebung eine Einheit aus zwei Umsetzungskanälen (11, 13; 12, 14) in Quadraturlage besitzt, wobei die Umsetzungsfrequenz der Verschiebefrequenz (Fd) des Niederfrequenzsignals gleicht.

5. Vorrichtung nach Anspruch 4, dadurch gekennzeichnet, daß jeder der Umsetzungskanäle der Vorrichtung (1) zur Verschiebung des Spektrums eine Multiplizierschaltung (11, 12) und daran gekoppelt ein digitales Filter (13, 14) enthält, um eine digitale Umsetzung des Niederfrequenzsignals auf die Verschiebefrequenz durchzuführen.

6. Vorrichtung nach Anspruch 5, dadurch gekennzeichnet, daß jedes digitale Filter (13, 14) der Vorrichtung zur Verschiebung des Spektrums an einen Digital-Analogwandler ($7_3$, $7_4$) eines Umsetzungskanals (3, 4) des Modulators gekoppelt ist, um das Niederfrequenzsignal, das am Ausgang des digitalen Filters (13, 14) erhalten wird, auf die Frequenz des Trägersignals umzusetzen.

**Claims**

1. Method for eliminating the signal residuals outside the working frequency band of transmitter-receivers of radio signals using a modulator-demodulator of signals in quadrature which is composed of two channels in quadrature (3, 4) and according to which the low-frequency signal to be transmitted which is applied to the input of the two channels is mixed with a carrier signal provided by a local oscillator (5), characterized in that it consists in shifting the spectrum of the low-frequency signal to be broadcast which is applied to the channels in quadrature and in removing by filtering (10) the undesirable vestigial band of the spectrum of the signal obtained at the output of the two channels in quadrature with a filter whose passband is set to the working frequency band of the transmitter.

2. Method according to Claim 1, characterized in that the frequency shift of the spectrum of the low-frequency signal takes place on each of the channels by digital transposition of the frequency of the low-frequency signal with two signals of equal frequency (Fd) which are sampled in quadrature.

3. Device for eliminating the signal residuals outside the working frequency band of a transmitter of radio signals using a modulator of signals in quadrature comprising two transposition channels in quadrature (3, 4) for transposing a low-frequency signal to be broadcast to the frequency of the carrier signal and a passband filter (10) coupled at the output of the two transposition channels (3, 4) for filtering one of the two sidebands of the signal resulting from the transposition, characterized in that it comprises a device for shifting the spectrum (1) of the low-frequency signal to be broadcast which is coupled to the input of the two channels (3, 4).

**4.** Device according to Claim 3, characterized in that the spectral shift device includes a set of two frequency-transposition channels (11, 13; 12, 14) in quadrature, the transposition frequency being equal to the shift frequency (Fd) of the low-frequency spectrum.

**5.** Device according to Claim 4, characterized in that each of the transposition channels of the spectral shift device (1) comprises a multiplier circuit (11, 12) coupled to a digital filter (13, 14) for performing a digital transposition of the low-frequency signal onto the shift frequency.

**6.** Device according to Claim 5, characterized in that each digital filter (13, 14) of the spectral shift device is coupled to a digital analogue converter ($7_3$, 74) of a transposition channel (3, 4) of the modulator for transposing the low-frequency signal obtained at the output of the digital filter (13, 14) to the frequency of the carrier signal.

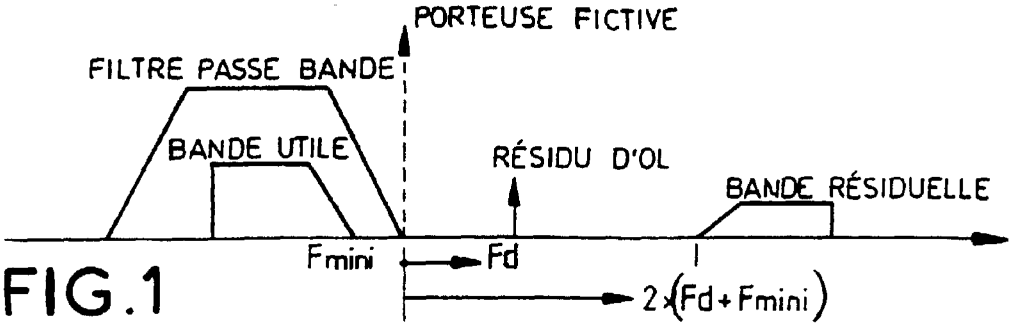


FIG.1

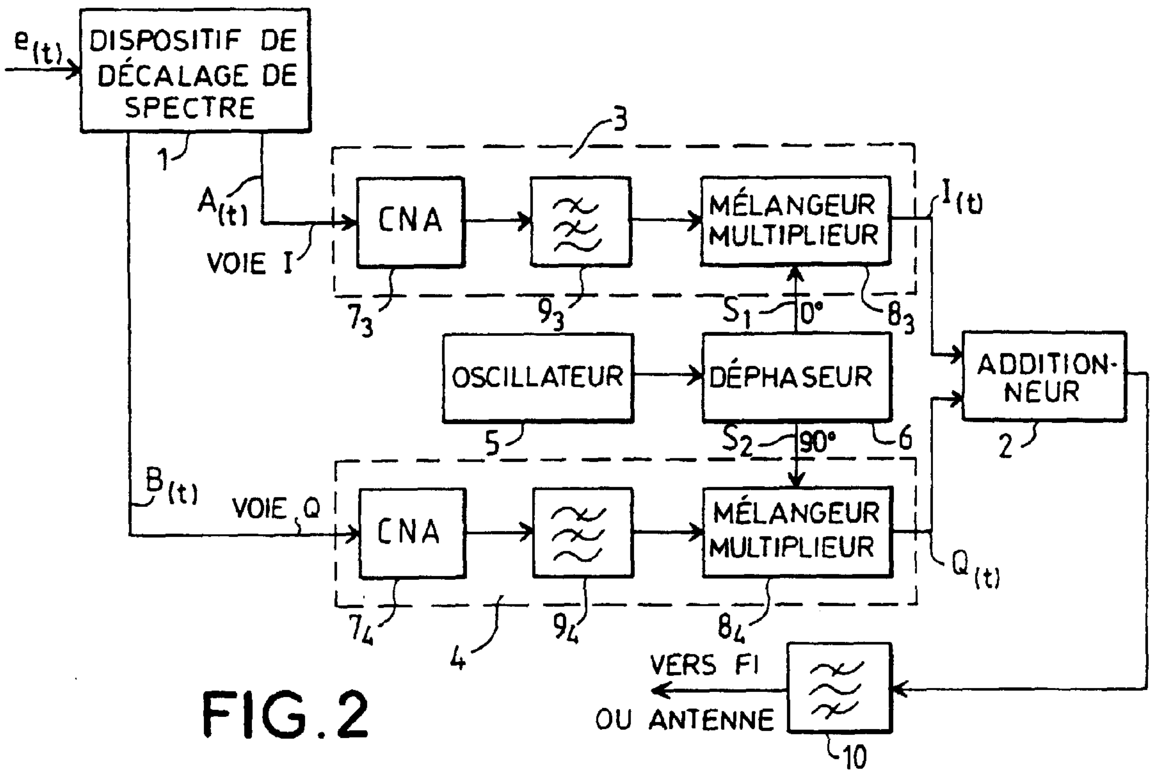


FIG.2

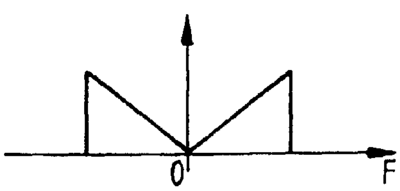


FIG.3A

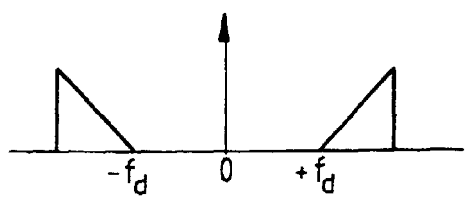


FIG.3B

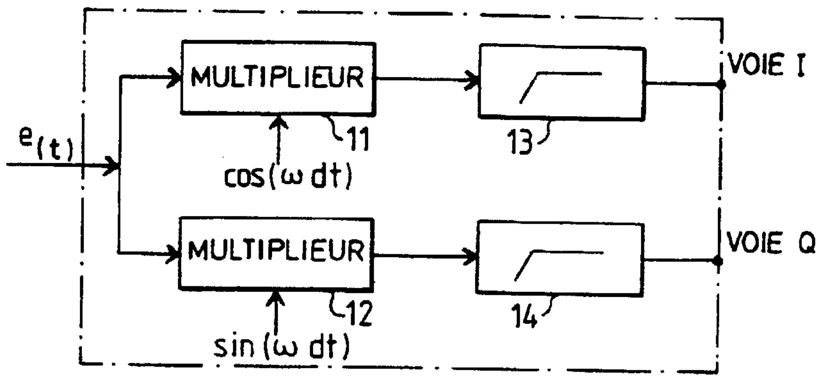
MULTIPLIEUR
MULTIPLIEUR
e(t)
cos(ω dt)
sin(ω dt)
11
12
13
14
VOIE I
VOIE Q

FIG.4

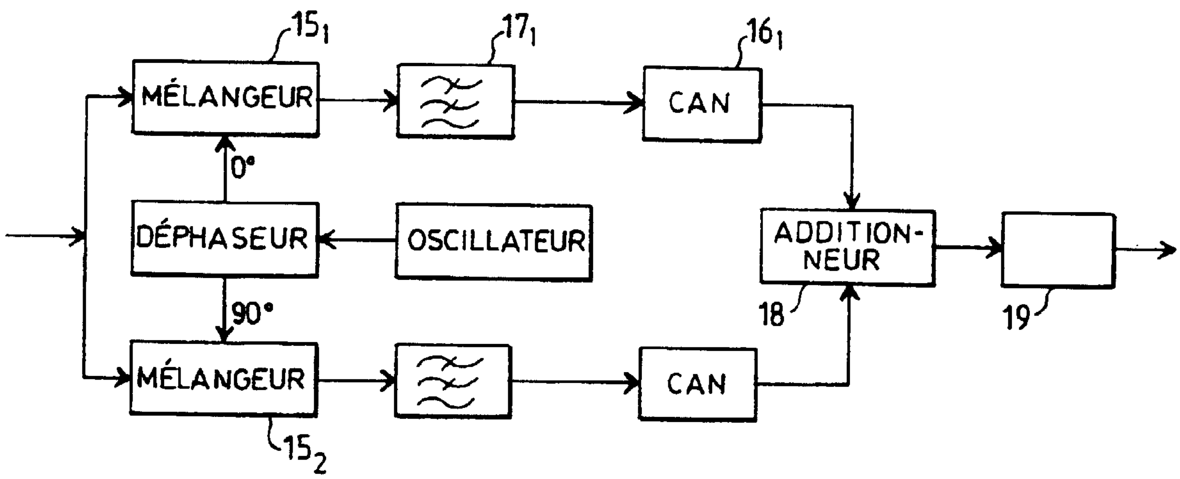
MÉLANGEUR
MÉLANGEUR
DÉPHASEUR
OSCILLATEUR
CAN
CAN
ADDITION-
NEUR
0°
90°
15 1
15 2
17 1
16 1
18
19

FIG.5